# EUROPEAN PATENT SPECIFICATION

(11) **EP 2 287 095 B1**
(45) Date of publication and mention of the grant of the patent: **21.08.2013**
(21) Application number: 09746719.5
(22) Date of filing: 17.03.2009
(51) Int. Cl.: B65G 49/06, H01L 21/68, B25J 15/06, B65G 47/91

(54) **NON-CONTACT TYPE OF VACUUM PAD**
KONTAKTFREIES VAKUUMKISSEN
VENTOUSE À VIDE DE TYPE SANS CONTACT

(30) Priority: 13.05.2008 KR 20080043850
(43) Date of publication of application: 23.02.2011
(73) Proprietor: Korea Pneumatic System Co., Ltd, Seoul 153-030 (KR)
(72) Inventor: CHO, Ho-Young, Gwangmyeong-si Gyeonggi-do 423-826 (KR)
(74) Representative: Richardt Patentanwälte GbR
(86) International application number: PCT/KR2009/001317
(87) International publication number: WO 2009/139540

(56) References cited:
- WO-A1-97/03457
- WO-A1-2005/086225
- JP-A- 2003 245 885
- JP-A- 2005 051 260
- JP-A- 2006 181 682
- JP-A- 2006 339 234
- KR-A- 20080 030 945
- US-A- 5 169 196

## Description

### Technical Field

The present invention relates, in general, to a vacuum pad, according to the preamble of claim 1, which is utilized for holding an article in a vacuum conveying system and, more particularly, to a non-contact type vacuum pad which is capable of holding an article in a non-contact state.

### Background Art

A vacuum conveying system is a system that creates negative pressure in a vacuum pad using compressed air and uses the created negative pressure to hold an article so that it can be conveyed to a predetermined place. It is common to use a contact type vacuum pad in this system. However, the contact type vacuum pad is problematic in that it is in direct contact with a surface of the article, so that its surface becomes damaged or contaminated.

Especially, a panel or the like used for a display of an electronic product is susceptible to fine scratches or deformation or impurities, so that the contact type pad is unsuitable for conveying the article. Thus, recently, the demand for a non-contact type pad is gradually increasing.

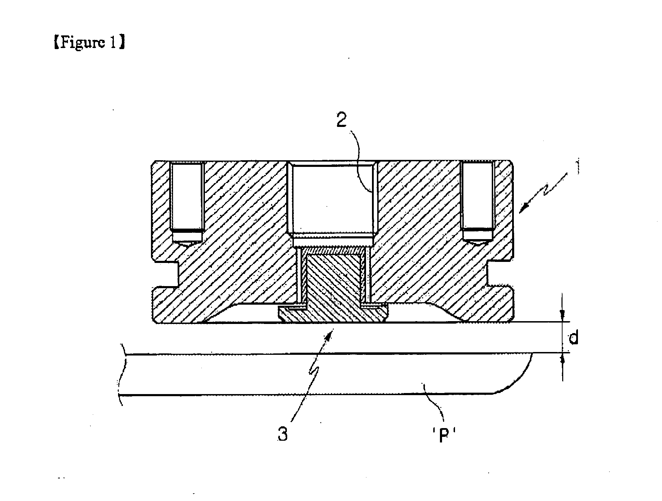

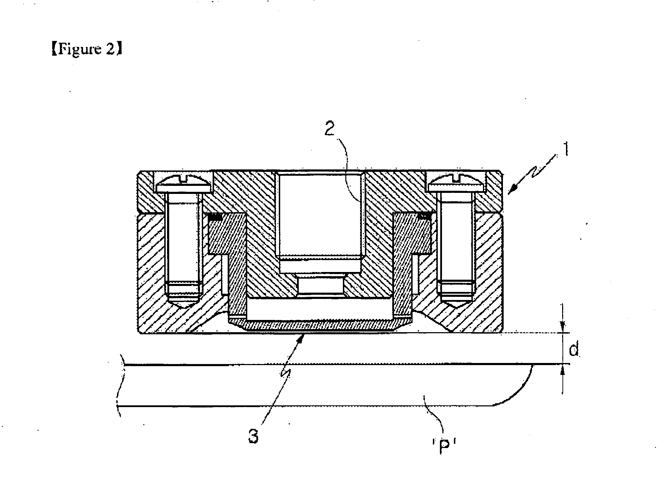

Conventional non-contact type vacuum pads are illustrated in Figs. 1 and 2. The same reference numerals are used in the two drawings to designate the same or similar components. As shown in the drawings, each non-contact type vacuum pad includes a main body 1 which has in a central portion thereof a compressed-air supply hole 2, and a guide 3 which is coupled to the lower portion of the main body 1, thus guiding the flow of air in a lateral direction.

The compressed air, which is supplied through the supply hole 2 of the main body 1 into the vacuum pad, is guided in the lateral direction by the guide 3, and passes through the edge of the lower surface of the main body 1 at high speed to be discharged to the outside. At this time, according to the Bernoulli effect, a vacuum is created between the vacuum pad and an article P, and negative pressure is generated by a difference in pressure between the vacuum and the atmospheric pressure.

The negative pressure causes the article P to come in proximity to and be held by the vacuum pad. However, a non-contact state is maintained between the vacuum pad and the article P, because they are spaced apart from each other by a minimum gap d by the discharge pressure of the compressed air. For this reason, it is called a non-contact type vacuum pad.

When comparing the non-contact type vacuum pad with the contact type pad, the non-contact type vacuum pad is considerably advantageous in the handling of an article that needs to maintain a precision surface. However, this

type of vacuum pad is problematic in that there is a limitation with respect to the vacuum strength that can be achieved, and it takes a long time to reach the maximum of the strength. Thus, it is not reliably used to handle an article that is heavy.

For example, the non-contact type vacuum pad may obtain a higher vacuum strength by supplying a larger amount of compressed air at higher speed, and discharging the compressed air at higher speed. However, in this case, there is an excessively large amount of energy consumed.

As another prior art, a non-contact type gripper is disclosed in Korean U.M. Registration No. 401259. The gripper includes a vacuum hose which passes through a non-contact pad corresponding to the guide 3 and extends to the outside. Although not explained therein, the vacuum hose is connected to a separate vacuum pump.

In the gripper, the vacuum pump is driven so that air present underneath the non-contact pad is forcibly discharged. Thus, compared to the non-contact type vacuum pad, the gripper can more rapidly obtain a stronger vacuum. However, the gripper is problematic in that it requires a complex design including the vacuum hose, its mounting structure, and the vacuum pump. Further, the gripper is problematic in that energy for driving the vacuum pump as well as energy for holding an article is required.

Yet another prior art non-contact gripper is described in WO 97/03957, which corresponds to the preamble of claim 1. A disclosed configuration of a support for a wafer shaped object is based on Bernoulli's principle. The object is held in contact with a ring of the support and prevented from moving in a direction parallel to a face of the support without requiring lateral supports such as projections or the like.

### Disclosure

### Technical Problem

Accordingly, the present invention has been made keeping in mind the above problems occurring in the prior art, and an object of the present invention is to provide a vacuum pad, which is capable of obtaining a reliable level of negative pressure and a reliably strong vacuum when handling an article that is heavy.

Another object of the present invention is to provide a non-contact type vacuum pad, which can improve energy efficiency using a simple design, thus being very advantageous in an economic point of view.

### Technical Solution

In order to accomplish the above objects, the present invention provides a non-contact type vacuum pad including a main body, an air guide, and a discharge passage defined by the main body and the guide. The main body has a compressed-air supply hole formed in a central portion thereof, and an outwardly flared surface formed on a lower end of the supply hole. Such a construction is not different from the conventional vacuum pad.

The air guide is mounted to the main body in such a way that the air guide does not protrude from a bottom edge of the main body, and has a central inflow recess which communicates with the supply hole, at least one flow pathway which is formed from the inflow recess through a wall surface, and a suction hole which extends from a bottom surface and is connected to the flow pathway. Further, the discharge passage is the passage through which compressed air supplied to the supply hole is discharged, and extends from the flow pathway of the guide to the flared surface and the edge of the main body,

Preferably, the flow pathway may comprise a plurality of flow pathways which are radially arranged around the inflow recess. More preferably, each flow pathway may comprise flow pathways which are arranged in series and in multiple stages. The suction hole may be formed between neighboring flow pathways. The suction hole may have an annular shape. Preferably, the suction hole may have on a lower end thereof a flared surface. Such a construction is useful for rapidly and smoothly sucking in outside air.

Further, preferably, a lower surface of a middle portion of the guide may be placed to be further inside than a lower surface of an outer portion of the guide. Such a configuration provides a larger vacuum space as compared to the configuration wherein the lower surface of the central portion of the guide is on the same level with the lower surface of the outer portion, thus attaining a larger vacuum space, therefore obtaining a stronger vacuum and greater holding force.

### Advantageous Effects

According to the present invention, a vacuum pad is advantageous in that, when compressed air passes through a discharge passage at high speed, outside air present underneath the vacuum pad is sucked in and then is discharged along with the compressed air, so that a higher vacuum strength is more rapidly achieved. Thus, the vacuum pad is advantageous in that it can be reliably applied when handling an article that is heavy. Meanwhile, in order to accomplish the effect, a complex design, a larger amount of energy or an additional energy source are not required. Therefore, the vacuum pad is very advantageous in terms of economics and energy efficiency.

### Description of Drawings

Fig. 1 is a sectional view showing a conventional non-contact type vacuum pad;
Fig. 2 is a sectional view showing another conventional non-contact type vacuum pad;
Fig. 3 is a sectional view showing a non-contact type vacuum pad according to the present invention;
Fig. 4 is a bottom view showing an air guide applied to Fig. 3; and
Fig. 5 is a view illustrating the operation of the non-contact type vacuum pad according to the present invention.

### <Description of reference characters of important parts>

11. main body
12. guide
13. supply hole
14. flared surface
18. flow pathway
19. suction hole
20. flared surface

### Mode for Invention

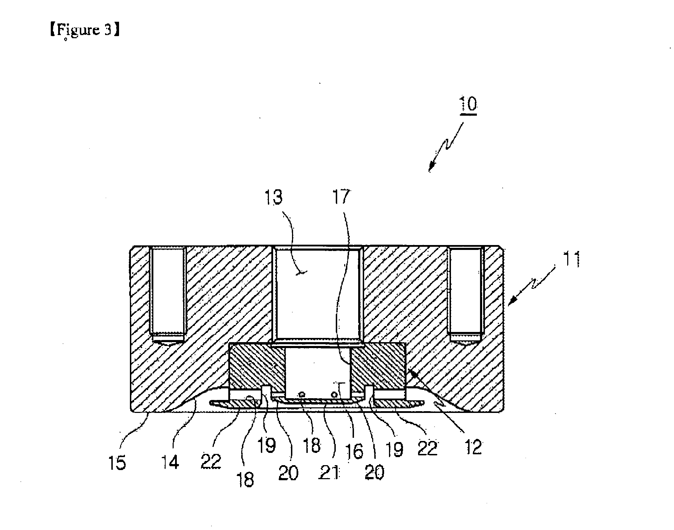

The above or other characteristics and effects of the present invention may be more obvious based on the description of the embodiment of the present invention which is illustrated below with reference to Figs. 3 to 5.

Referring to Fig. 3, a non-contact type vacuum pad of the present invention is denoted by reference numeral 10. The vacuum pad 10 includes a main body 11, a guide 12 which is coupled to the lower portion of the main body 11, and a compressed-air discharge passage which is provided between the main body 11 and the guide 12. Here, the main body 11 has a compressed-air supply hole 13 which is formed in the central portion of the main body, and an outwardly flared surface 14 which is formed on the lower end of the supply hole 13. The construction is not different from that of the conventional vacuum pad. However, the outwardly flared surface may be selected from an inclined surface or a round surface.

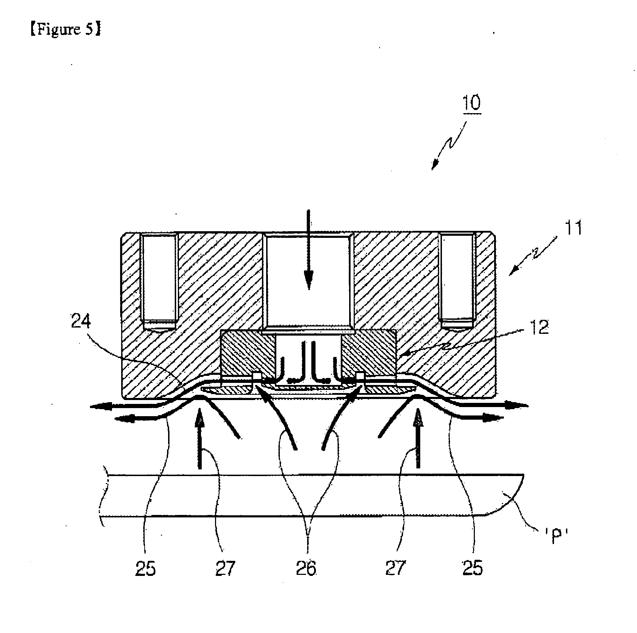

The air guide 12 is mounted to the main body 11 in such a way that it does not protrude from a bottom edge 15 of the main body. Preferably, the air guide is mounted to the main body 11 in such a way that it does not protrude from the outwardly flared surface 14 formed on the lower end of the supply hole 13. For example, if the guide 12 protrudes, the vacuum pad 10 may make contact with an article `P' (see Fig. 5).

The air guide 12 includes a central inflow recess 16 which communicates with the supply hole 13, at least one flow pathway 18 which is formed from the inflow recess 16 through a wall surface 17, and a suction hole 19 which extends from a bottom surface and is connected to the flow pathway 18. Although not shown in the drawings, a pipe-type nozzle may be mounted to the flow pathway 18.

The discharge passage is the place through which compressed air supplied to the supply hole 13 of the main body 11 is discharged, and extends from the flow pathway 18 of the guide 12 to the flared surface 14 and the edge 15 of the main body 11.

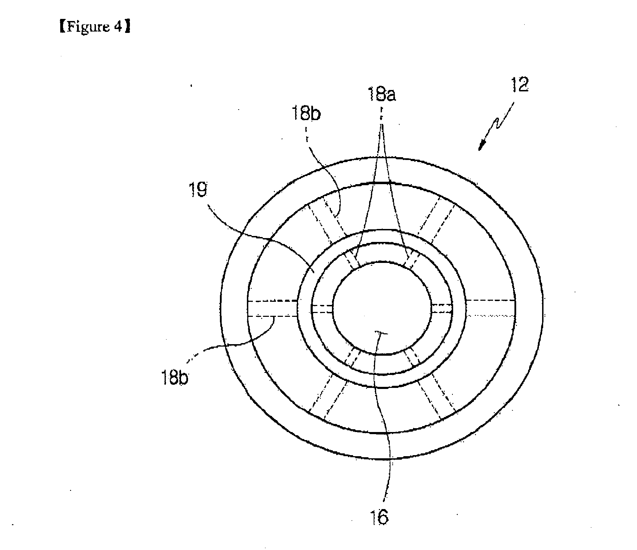

Referring to Fig. 4, a plurality of flow pathways 18 is formed in the guide 12 to be radially arranged around the inflow recess 16. If there are too many flow pathways 18, the speed at which the compressed air is discharged may be reduced. In order to solve the problem, it is necessary to ascertain what is the proper number of flow pathways. In the drawing, the suction hole 19 has the shape of one ring and communicates with each flow pathway 18. Such a construction is useful for rapidly and smoothly sucking in outside air, namely, air between the vacuum pad 10 and the article 'P' (see Fig. 5).

Each flow pathway 18 comprises flow pathways 18a and 18b which are arranged in series and in multiple stages in such a way that their diameters are increased. The suction hole 19 is placed between neighboring flow pathways 18a and 18b. Compressed air passes through the flow pathway 18a having a small diameter at the highest speed. Hence, outside air is introduced into the compressed air through the suction hole 19. Further, the outside air is combined with the compressed air at the flow pathway 18b having a large diameter and then discharged together with the compressed air. Such a shape of the flow pathway 18 is very effective in discharging the outside air.

Turning back to Fig. 3, the suction hole 19 has on the lower end thereof a flared surface 20. Such a construction is useful for rapidly and smoothly sucking in outside air underneath the vacuum pad 10. Meanwhile, a lower surface 21 of a middle portion of the guide 12 is placed to be further inside than a lower surface 22 of an outer portion thereof. Such a configuration provides a larger vacuum space in comparison with the configuration wherein the lower surface of the middle portion is on the same level with that of the outer portion. Thus, the vacuum pad 10 can attain a stronger vacuum and a greater holding force.

The lower surface 22 of the outer portion of the guide 12 extends and protrudes leftwards and rightwards. This guides the compressed air such that it is naturally discharged along the flared surface 14 after passing through the flow pathway 18.

Referring to Fig. 5, compressed air is supplied to the supply hole 13 of the main body 11, and flows into the inflow recess 16 of the guide 12. The compressed air then in sequence passes through the discharge passage, that is, the flow pathway 18, the flared surface 14, and the edge 15 and then is discharged to the outside (see arrows 24).

In this process, Bernoulli's effect is in effect. That is, some of the air present between the vacuum pad 10 and the article P is combined with the compressed air in the vicinity of the flared surface 14 and is discharged together with the compressed air (see arrows 25). Simultaneously, other air between the vacuum pad 10 and the article P passes through the suction hole 19, is introduced into the compressed air, and is combined with the compressed air at the flow pathway 18b to be discharged together with the compressed air (see arrows 26).

Thereby, vacuum and negative pressure are generated between the vacuum pad 10 and the article P, and the generated negative pressure causes the article P to come in proximity to and be held by the vacuum pad 10 (see arrows 27).

The above-mentioned vacuum pad 10 is constructed so that, when the compressed air passes through the discharge passage, the outside air existing underneath the vacuum pad is introduced into the compressed air in the vicinity of the flared surface 14 and through the suction hole 19, and is combined with the compressed air to be discharged together with the compressed air. Therefore, a very strong vacuum and negative pressure can be more rapidly created. Further, it is obvious that a complex design, a large amount of energy or an additional energy source are not required to accomplish the rapid creation of a strong vacuum and strong negative pressure.

## Claims

1. A non-contact type vacuum pad, comprising a main body (11) having a compressed-air supply hole (13) formed in a central portion thereof, and an outwardly flared surface (14) formed on a lower end of the supply hole (13); an air guide (12) mounted to the main body having a central inflow recess (16) which communicates with the supply hole, at least one flow pathway (18) which is formed from the inflow recess through a wall surface, and an annular-shaped suction hole (19) which extends from a bottom surface between a lower surface (21) of a middle portion of the airguide (12) and a lower surface (22) of an outer portion of the air guide (12), which section hole (19) is connected to the flow pathway (18); a compressed-air discharge passage extending from the flow pathway of the guide to the flared surface and the edge of the main body, wherein the flow pathway comprises flow pathways (18a, 18b) which are arranged in series and in multiple stages such that diameters of the flow pathways are increased, the suction hole (19) being placed between neighboring flow pathways; **characterized in that**:
the air guide is mounted to the main body in such a way that the air guide does not protrude from a bottom edge of the main body, wherein the lower surface (21) of the middle portion of the air guide (12) is placed to be further inside than the lower surface (22) of the outer portion of the air guide (12).

2. The non-contact type vacuum pad according to claim 1, wherein the flow pathway comprises a plurality of flow pathways (18) which are radially arranged around the inflow recess (16).

3. The non-contact type vacuum pad according to claim 1, wherein the suction hole (19) has on a lower end thereof a flared surface (14).

4. The non-contact type vacuum pad according to claim 1, wherein a pipe-type nozzle is mounted in the flow pathway (18).

5. The non-contact type vacuum pad according to claim 1, wherein the outwardly flared surface (14) of
the main body (14) is an inclined surface or a round surface.

6. The non-contact type vacuum pad according to claim 1, wherein the lower surface (22) of the outer portion of the guide extends and protrudes leftwards and rightwards.

## Patentansprüche

1. Berührungsloser Vakuumgreifer, aufweisend: einen Hauptkörper (11) mit einer Druckluft-Zufuhröffnung (13), die in einem zentralen Abschnitt des letzteren ausgebildet ist, und mit einer nach außen aufgeweiteten Oberfläche (14), die an einem unteren Ende der Zufuhröffnung (13) ausgebildet ist; eine Luftführung (12), die am Hauptkörper angebracht ist und eine zentrale Zustromaussparung (16) aufweist, die mit der Zufuhröffnung in Verbindung steht, mindestens einen Strömungsweg (18), der ausgehend von der Zustromaussparung durch eine Wandfläche hindurch ausgebildet ist; und eine ringförmige Ansaugöffnung (19), die sich von einer Bodenfläche zwischen einer unteren Oberfläche (21) eines mittleren Abschnitts der Luftführung (12) und einer unteren Oberfläche (22) eines äußeren Abschnitts der Luftführung (12) erstreckt, wobei die Ansaugöffnung (19) mit dem Strömungsweg (18) verbunden ist; einen Druckluft-Auslasskanal, der sich vom Strömungsweg der Führung zur aufgeweiteten Oberfläche und zum Rand des Hauptkörpers erstreckt, wobei der Strömungsweg Strömungswege (18a, 18b) umfasst, die in Reihe und auf mehreren Stufen so angeordnet sind, dass Durchmesser der Strömungswege größer werden, wobei die Ansaugöffnung (19) zwischen benachbarten Strömungswegen angeordnet ist; **dadurch gekennzeichnet, dass**:
die Luftführung auf solche Weise am Hauptkörper angebracht ist, dass die Luftführung nicht von einem unteren Rand des Hauptkörpers vorsteht, wobei die untere Oberfläche (21) des mittleren Abschnitts der Luftführung (12) so angeordnet ist,
dass sie sich weiter innen befindet als die untere Oberfläche (22) des äußeren Abschnitts der Luftführung (12).

2. Berührungsloser Vakuumgreifer nach Anspruch 1, wobei der Strömungsweg (18) eine Mehrzahl von Strömungswegen (18) umfasst, die radial um die Zustromaussparung (16) herum angeordnet sind.

3. Berührungsloser Vakuumgreifer nach Anspruch 1, wobei die Ansaugöffnung (19) an einem unteren Ende eine aufgeweitete Oberfläche (14) aufweist.

4. Berührungsloser Vakuumgreifer nach Anspruch 1, wobei eine rohrartige Düse im Strömungsweg (18) angebracht ist.

5. Berührungsloser Vakuumgreifer nach Anspruch 1, wobei die nach außen aufgeweitete Oberfläche (14) des Hauptkörpers (14) eine schräge Oberfläche oder eine runde Oberfläche ist.

6. Berührungsloser Vakuumgreifer nach Anspruch 1, wobei die untere Oberfläche (22) des äußeren Abschnitts der Führung sich nach links und rechts erstreckt und vorsteht.

## Revendications

1. Ventouse du type sans contact, comprenant un corps principal (11) avec un orifice d'alimentation en air comprimé (13) formé dans une partie centrale de celui-ci, et une surface évasée vers l'extérieur (14) formée à une extrémité inférieure de l'orifice d'alimentation (13) ; un guide d'air (12) monté sur le corps principal et possédant une cavité d'admission centrale (16) communiquant avec l'orifice d'alimentation, au moins une voie d'écoulement (18) formée à partir de la cavité d'admission et à travers une surface de paroi, et un orifice d'aspiration de forme annulaire (19) s'étendant à partir d'une surface inférieure, entre une surface inférieure (21) d'une partie du milieu du guide d'air (12) et une surface inférieure (22) d'une partie extérieure du guide d'air (12), ledit orifice d'aspiration (19) étant relié à la voie d'écoulement (18) ; un passage de décharge d'air comprimé s'étendant à partir de la voie d'écoulement du guide jusqu'à la surface évasée et au bord du corps principal, dans laquelle la voie d'écoulement comprend des voies d'écoulement (18a, 18b) agencées en séries et sur plusieurs niveaux, de telle sorte que les diamètres des voies d'écoulement augmentent, l'orifice d'aspiration (19) étant placé entre des voies d'écoulement adjacentes ; **caractérisée en ce que** :
le guide d'air est monté sur le corps principal de manière à ce que le guide d'air ne fasse pas saillie à partir d'un bord inférieur du corps principal, la surface inférieure (21) de la partie du milieu du guide d'air (12) étant placée de manière à se trouver plus à l'intérieur que la surface inférieure (22) de la partie extérieure du guide d'air (12).

2. Ventouse du type sans contact selon la revendication 1, dans laquelle la voie d'écoulement (18) comprend une pluralité de voies d'écoulement (18) agencées radialement autour de la cavité d'admission (16).

3. Ventouse du type sans contact selon la revendication 1, dans laquelle l'orifice d'aspiration (19) possède une surface évasée à une extrémité inférieure de celui-ci.

4. Ventouse du type sans contact selon la revendication 1, dans laquelle une buse du type tuyau est montée dans la voie d'écoulement (18).

5. Ventouse du type sans contact selon la revendication 1, dans laquelle la surface évasée vers l'extérieur (14) du corps principal (14) est une surface inclinée ou une surface ronde.

6. Ventouse du type sans contact selon la revendication 1, dans laquelle la surface inférieur (22) de la partie extérieure du guide s'étend et fait saillie vers la gauche et vers la droite.
